# DEMANDE DE BREVET EUROPEEN

(11) **EP 1 811 675 A1**
(43) Date de publication de la demande: **25.07.2007**
(21) Numéro de dépôt: 06126109.5
(22) Date de dépôt: 14.12.2006
(51) Int. Cl.: H04B 1/04, H03F 1/56, H01P 5/103

(54) **Dispositif d'adaptation, notamment d'amplificateur de puissance**

(30) Priorité: 20.12.2005 FR 0512959
(71) Demandeur: THALES, 92200 Neuilly sur Seine (FR)
(72) Inventeur: Todeschini, Albert, 91430 Igny (FR); Marcoux, Jean, 78460 Chevreuse (FR); Liabeuf, Bernard, 92120 Montrouge (FR)
(74) Mandataire: Lucas, Laurent Jacques

(57) **Abrégé**

L'invention concerne un dispositif d'adaptation, notamment d'amplificateur de puissance. Le dispositif d'adaptation comporte une entrée (22) reliée à un dispositif en entrée (2) délivrant un signal utile, une sortie (20) reliée un dispositif de sortie (4), un corps (25) reliant l'entrée (22) à la sortie (20), des moyens de filtrage (23) du signal délivré par le dispositif d'entrée (2), une charge adaptée (24). Le dispositif d'entrée (2) fonctionne de manière linéaire ou quasi-linéaire sur une bande de fréquence plus importante que le dispositif de sortie (4). Les moyens de filtrage (23) assurent la fonction de filtre stop-bande et sont adaptés par la charge adaptée (24) au dispositif d'entrée (2) dans toute la bande de fréquence de fonctionnement linéaire ou quasi-linéaire du dispositif d'entrée (2), à l'exception de la bande de fréquence stoppée par les moyens de filtrage (23). La bande de fréquence stoppée correspond sensiblement à la bande de fréquence du signal utile. En particulier, l'invention s'applique aux amplificateurs de puissance à large bande de fréquence dont le signal de sortie est dirigé vers un dispositif fonctionnant dans une bande de fréquence plus réduite.

## Description

L'invention concerne un dispositif d'adaptation, notamment d'amplificateur de puissance. En particulier, l'invention s'applique aux amplificateurs de puissance à large bande de fréquence dont le signal de sortie est dirigé vers un dispositif fonctionnant dans une bande de fréquence plus réduite. Il peut notamment s'agir d'un amplificateur de puissance large bande relié via un guide d'onde à une antenne dont la bande de fréquence est plus réduite.

Dans un système utilisant la propagation électromagnétique, tels que radars, brouilleurs ou communications hertziennes, les systèmes d'émission sont généralement pourvus d'un amplificateur de forte puissance dont la fonction principale est d'augmenter le niveau du signal véhiculant les informations sur une gamme de fréquence étendue de façon à obtenir la distance nécessaire de la liaison. La sortie de l'amplificateur est connectée à un guide d'onde chargé de véhiculer le signal de sortie vers une antenne émettrice. Or, le guide d'onde et l'antenne émettrice fonctionne généralement dans une plage de fréquence plus restreinte que l'amplificateur de puissance. Dans ces conditions, le dispositif antennaire peut présenter des conditions d'impédance de charge mal contrôlées en dehors de la bande de fréquence utile du système. D'autre part, les amplificateurs de puissance hyperfréquences sont généralement sensibles aux impédances de charge, pouvant conduire à des instabilités se traduisant par des oscillations parasites et la création d'harmoniques générées par les non linéarités de l'amplificateur. Le signal utile est dans ce cas fortement perturbé ce qui peut conduire à une défaillance totale du système et également à une pollution de l'environnement électromagnétique.

Pour compenser ces effets néfastes il est d'usage d'intercaler entre l'amplificateur de puissance et l'antenne des filtres diplexeurs, triplexeurs ou multiplexeurs agissant comme filtre fréquentiel et permettant de maîtriser les conditions d'impédance dans chacune des sous-bandes de fréquence ainsi découpées, et ce , même en dehors de la plage de fréquence strictement utile. En contrepartie de l'utilisation de ces filtres, le signal arrivant à l'antenne est affaibli par les pertes liées au filtrage. De plus, outre le coût important de cette solution, l'emcombrement peut devenir prohibitif pour des systèmes de communications embarqués.

L'invention a notamment pour but de pallier les inconvénients précités. A cet effet, l'invention a pour objet un dispositif d'adaptation comportant :
- une entrée assurant la connexion avec un dispositif en entrée délivrant un signal utile ;
- une sortie assurant la connexion avec un dispositif de sortie ;
- un corps reliant l'entrée à la sortie ;
- des moyens de filtrage du signal délivré par le dispositif d'entrée ;
- une charge adaptée.
Le dispositif d'entrée fonctionne de manière linéaire ou quasi-linéaire sur une bande de fréquence plus importante que le dispositif de sortie. Les moyens de filtrage assurent la fonction de filtre stop-bande et sont adaptés par la charge adaptée au dispositif d'entrée dans toute la bande de fréquence de fonctionnement linéaire ou quasi-linéaire du dispositif d'entrée, à l'exception de la bande de fréquence stoppée par les moyens de filtrage. La bande de fréquence stoppée correspond sensiblement à la bande de fréquence du signal utile.

Dans un mode de réalisation, le dispositif de sortie assurant une fonction de filtre passe-haut, les moyens de filtrage assurent la fonction de filtre passe-bas ou passe-bande complémentaire à l'effet de filtrage passe-haut du dispositif de sortie. La bande de fréquence stoppée correspond alors sensiblement à la bande de fréquence du signal utile.

Le dispositif d'entrée peut être un amplificateur de puissance et que le dispositif de sortie est un guide d'onde. Il peut alors avantageusement comporter un élément rayonnant entre un point d'entrée des moyens de filtrage et l'entrée. Le point d'entrée est maintenu à un potentiel électrique nul ou quasi-nul. Des éléments réjecteurs sont alors intercalés entre le point d'entrée et la charge adaptée.

L'invention a notamment pour avantages qu'elle permet de s'intégrer facilement à des systèmes de communication existant. En outre, de part l'utilisation des caractéristiques du guide d'onde du système de communication, le coût de fabrication est réduit par rapport aux solutions habituelles. Enfin sa réalisation, directement à base de guide d'onde, est particulièrement bien adaptée au traitement des fortes puissances mises en jeu dans ce type d'applications.

D'autres caractéristiques et avantages de l'invention apparaîtront à l'aide de la description qui suit faite en regard des dessins annexés qui représentent :
- la figure 1, un synoptique d'un système d'émission selon l'état de l'art;
- la figure 2, un diagramme représentant le gain du signal de sortie de l'amplificateur de puissance en fonction de la fréquence du signal d'entrée ainsi que les bandes de fréquences du signal utile et de fonctionnement de l'antenne et du guide d'onde ;
- la figure 3, un dispositif d'adaptation d'amplificateur de puissance selon l'invention ;
- la figure 4, un synoptique d'un mode de réalisation du dispositif d'adaptation d'amplificateur de puissance selon l'invention.

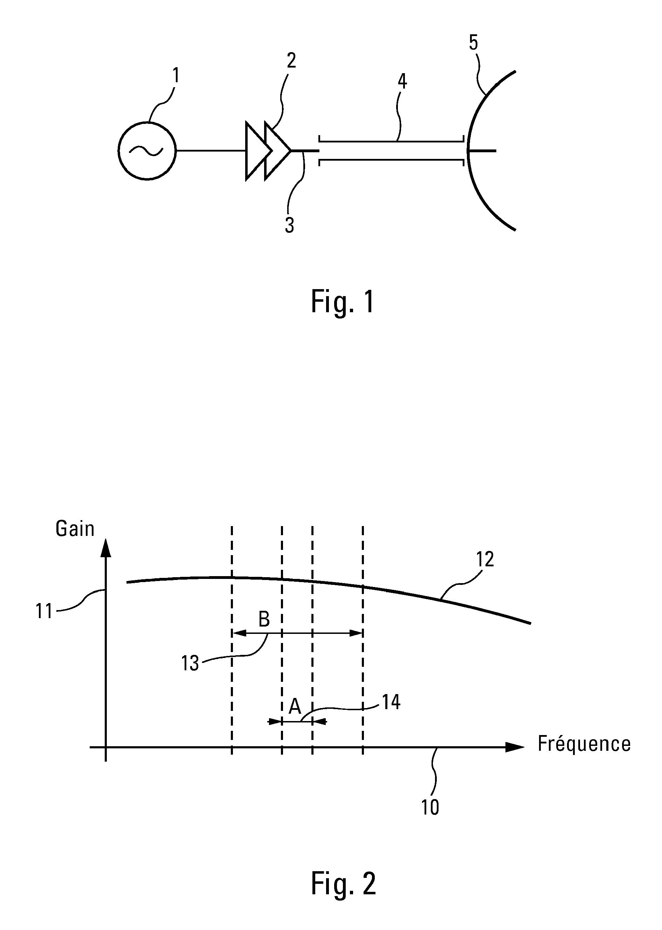

La figure 1 illustre par un synoptique, un système d'émission selon l'état de l'art. Dans un système de communications, un système d'émission, comme représenté sur la figure 1, comporte généralement un amplificateur de puissance 2. L'amplificateur de puissance 2 reçoit le signal utile, comportant les informations à transmettre, généré par une source 1. A titre d'exemple, l'ordre de grandeur de la puissance du signal de sortie d'un amplificateur peut être de quelques centaines de watts. Cet amplificateur peut présenter un gain important dans une plage de fréquence étendue, bande C à la bande Ku, c'est-à-dire entre 4 GHz et 18GHz par exemple, bande largement supérieure à la bande utile de fonctionnement, typiquement dans l'exemple de 1 GHz. Le signal amplifié en sortie de l'amplificateur 2 est ensuite transmis dans un guide d'onde 4. Le transfert du signal amplifié de l'amplificateur de puissance 2 vers le guide d'onde 4 est généralement assuré par un dispositif de transition 3, comme par exemple un câble coaxial et une transition guide/coaxial. Le dispositif de transition 3 a pour fonction de relier physiquement la sortie de l'amplificateur de puissance 2 au guide d'onde 4, en modifiant le moins possible les caractéristiques du signal. Le guide d'onde 4 débouche sur une antenne 5 dont une des fonctions est de transmettre le signal amplifié reçu. Le guide d'onde 4 contribue à l'acheminement du signal amplifié délivré à la sortie de l'amplificateur 2 vers l'antenne 5. Or, le guide d'onde 4 et l'antenne 5 ne fonctionne pas nécessairement en respectant les conditions d'impédance permettant d'assurer la stabilité de l'amplificateur de puissance 2 sur une gamme de fréquence aussi étendue que celle de l'amplificateur de puissance 2. Au signal utile amplifié par l'amplificateur de puissance 2 peut alors s'ajouter non seulement des harmoniques mais aussi oscillations parasites incontrôlées perturbant le signal utile. L'amplificateur de puissance 2 peut alors se mettre à osciller et perturber le signal utile et/ou l'ensemble du spectre de fréquence.

La figure 2 représente par un diagramme le gain du signal de sortie de l'amplificateur de puissance en fonction de la fréquence du signal d'entrée ainsi que les bandes de fréquences du signal utile et de fonctionnement de l'antenne et du guide d'onde. Les éléments identiques aux éléments déjà présentés sur les autres figures portent les mêmes références. L'axe des abscisses 10 représente la fréquence du signal utile injecté à l'entrée de l'amplificateur de puissance 2. L'axe des ordonnées indique le gain du signal de sortie de l'amplificateur de puissance 2 en fonction de la fréquence du signal utile reçue en entrée. La courbe 12 représente le gain du signal de sortie de l'amplificateur de puissance 2 en fonction de la fréquence du signal utile reçue en entrée. La courbe 12 est propre à chaque amplificateur de puissance 2 utilisé. Sur ce même diagramme est représenté la bande de fréquence 13 de fonctionnement linéaire ou quasi-linéaire de l'antenne 5 associée au guide d'onde 4. La bande de fréquence 13 est sensiblement plus limitée que la plage de fonctionnement linéaire ou quasi-linéaire de l'amplificateur de puissance 2. A titre d'exemple, la bande de fréquence 14 nécessaire au signal utile est généralement inférieure à la bande de fréquence 13 de l'antenne 5 associée au guide d'onde 4.

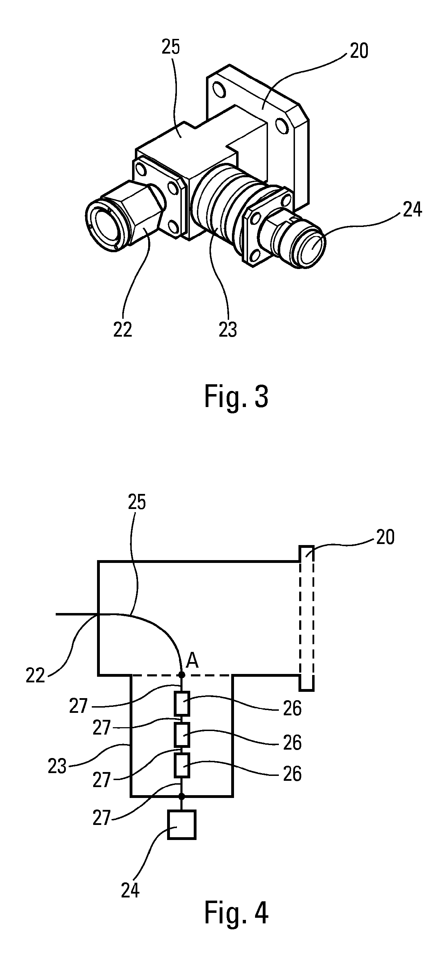

La figure 3 montre un dispositif d'adaptation d'amplificateur de puissance selon l'invention. Les éléments identiques aux éléments déjà présentés sur les autres figures portent les mêmes références. Le guide d'onde 4 agit de part les caractéristiques qui lui sont propres comme un filtre passe-haut. A titre d'exemple, si l'on considère un signal utile compris dans une des bandes de fréquence entre C et Ku, le guide d'onde 4 se comporte comme un filtre passe haut ayant une fréquence de coupure autour de 9.5 GHz. Or la charge présentée à l'amplificateur de puissance 2 pour des fréquences inférieures à cette fréquence de coupure est complètement désadaptée. Dans ces conditions, l'amplificateur risque d'osciller. Le dispositif d'adaptation d'amplificateur de puissance selon l'invention permet de présenter à l'amplificateur de puissance 2 une charge adaptée, c'est-à-dire un taux d'onde stationnaire inférieur à 3, dans une très large bande de fréquence, par exemple entre la bande C et la bande Ku.

Le dispositif d'adaptation d'amplificateur de puissance selon l'invention comporte notamment une entrée 22 assurant la connexion avec le câble de sortie de l'amplificateur de puissance 2. Le dispositif selon l'invention comporte en outre une sortie 20 assurant la connexion physique avec le guide d'onde 4. Un corps 25 relie l'entrée 22 à la sortie 20. La forme dudit corps 25 dépend des caractéristiques de propagation électromagnétique souhaitées pour le signal véhiculant entre l'entrée 22 et la sortie 20, ainsi que des contraintes mécaniques du système utilisant ledit dispositif. Sur la figure 3, le corps 25 est un corps fermé creux.

Le dispositif selon l'invention comporte encore des moyens de filtrage 23 du signal amplifié délivré par l'amplificateur de puissance en sortie reçu via l'entrée 22. Avantageusement, comme montré sur la figure 3, les moyens de filtrage 23 sont montés perpendiculairement au corps 25. Les moyens de filtrage 23 assure la fonction de filtre stop-bande. Les moyens de filtrage 23 sont adaptés à l'amplificateur de puissance 2 dans toute la bande de fréquence, à l'exception de la bande stoppée par lesdits moyens de filtrage 23. La bande stoppée correspond sensiblement à la bande de fréquence 14 du signal utile. Pour ce faire, les moyens de filtrage 23 peuvent par exemple comporter une charge adaptée 24. Ainsi dans la bande de fréquence 14 du signal utile, la puissance du signal amplifié est quasi intégralement transmise à l'antenne 4 via le guide d'onde 4. En dehors de la bande de fréquence 14 du signal utile, le dispositif selon l'invention présente une charge adaptée vue de l'entrée 22 et l'impédance présentée à l'amplificateur dans cette bande de fréquence, est celle de l'association moyen de filtrage 23 et charge 24. Le dispositif d'adaptation d'amplificateur de puissance selon l'invention a donc notamment pour effet de présenter à la sortie de l'amplificateur de puissance 2 un taux d'onde stationnaire maîtrisé, conduisant à assurer la stabilité de l'amplification.

Le dispositif d'adaptation d'amplificateur de puissance selon l'invention peut avantageusement s'intercaler entre la sortie de l'amplificateur de puissance 2 et le guide d'onde 4 en remplacement du dispositif de transition 3. Dans ce mode de réalisation particulièrement avantageux, le dispositif d'adaptation d'amplificateur de puissance selon l'invention permet alors d'adapter la transition entre le guide d'onde 4 et le câble de sortie de l'amplificateur (qui est généralement un câble coaxial ou une transition guide/coaxial), en dehors de la bande de fréquence de fonctionnement du guide d'onde 4. Le dispositif d'adaptation de puissance selon l'invention assure notamment dans un encombrement réduit d'une part la transition entre le câble de sortie de l'amplificateur de puissance 2 et d'autre part l'adaptation de l'amplificateur de puissance 2 dans sa bande de fréquence de fonctionnement (en particulier dans la bande de fréquence rejetée par le guide d'ondes 4).

La figure 4 illustre un synoptique du dispositif d'un mode de réalisation du d'adaptation d'amplificateur de puissance selon l'invention. Les éléments identiques aux éléments déjà présentés sur les autres figures portent les mêmes références. Le guide d'onde 4 agit de part les caractéristiques qui lui sont propres comme un filtre passe-haut. A titre d'exemple, si l'on considère un signal utile compris dans une des bandes de fréquence entre C et Ku, le guide d'onde 4 se comporte comme un filtre passe haut ayant une fréquence de coupure autour de 9.5 GHz. Dans un mode de réalisation, les moyens de filtrages 23 réalisent uniquement la fonction de filtre passe-bas ou passe-bande complémentaire à l'effet de filtrage passe-haut du guide d'onde pour réaliser une fonction de multiplexage décrit précédemment..

Dans un mode particulier de réalisation, le signal amplifié provenant de la sortie de l'amplificateur de puissance 2 entre dans le dispositif selon l'invention par l'entrée 22. Entre d'une part un point A correspondant au point d'entrée des moyens de filtrage 23 et d'autre part l'entrée 22, est disposé un élément rayonnant 25. L'élément rayonnant 25 permet d'assurer la conversion du signal amplifié sous forme électrique en ondes électromagnétiques dirigées via la sortie 20 vers le guide d'onde 4. Le point A est maintenu à un potentiel électrique nul ou quasi-nul. Entre le point A et la charge adaptée 24, le signal électrique parvenant à l'entrée des moyens de filtrage 23 parcourt des éléments réjecteurs 26. Par exemple, les moyens de filtrage 23 peuvent comporter trois tronçons (ou stubs selon l'expression anglo-saxonne) ayant une fréquence de coupure égale au quart de la longueur d'onde λ₀ de la fréquence à stopper et fonctionnant en court-circuits série séparés par des lignes 27 de longueur égale au quart de la longueur d'onde λ₀.

Le dispositif d'adaptation de puissance selon l'invention, peut avantageusement être utilisé dans un émetteur de système de communication. Toutefois, cette application n'est en rien limitative. En effet, le dispositif d'adaptation peut être utilisé dès qu'il s'agit d'adapter un dispositif dont la bande de fréquence de fonctionnement est sensiblement supérieure à un autre dispositif auquel il est relié. De la même manière, le dispositif peut être employé dès lors qu'il s'agit d'améliorer le taux d'ondes stationnaires à la sortie d'un dispositif. Les indications de bande de fréquence sont données à titre indicatif et ne modifient en rien le fonctionnement du dispositif selon l'invention. De manière générale, le dispositif selon l'invention comporte notamment une entrée assurant la connexion avec un dispositif en entrée délivrant un signal utile. Le dispositif selon l'invention comporte une sortie assurant la connexion physique avec un dispositif de sortie. Un corps relie l'entrée à la sortie et achemine le signal utile de l'entrée vers la sortie. Le dispositif d'entrée fonctionne de manière linéaire ou quasi-linéaire sur une bande de fréquence plus importante que le dispositif de sortie. Le dispositif selon l'invention comporte des moyens de filtrage du signal délivré par le dispositif d'entrée. Les moyens de filtrage assurent la fonction de filtre stop-bande et sont adaptés par une charge adaptée au dispositif d'entrée dans toute la bande de fréquence de fonctionnement linéaire ou quasi-linéaire du dispositif d'entrée, à l'exception de la bande stoppée par lesdits moyens de filtrage. La bande stoppée correspond sensiblement à la bande de fréquence du signal utile. En dehors de la bande de fréquence du signal utile, le dispositif selon l'invention présente une charge adaptée vue de l'entrée. Dans un mode de réalisation où le dispositif de sortie assure une fonction de filtre passe-haut, les moyens de filtrage peuvent assurer la fonction de filtre passe-bas

## Revendications

1. Dispositif d'adaptation **caractérisé en ce qu'**il comporte :
- une entrée (22) assurant la connexion avec un dispositif en entrée (2) délivrant un signal utile ;
- une sortie (20) assurant la connexion avec un dispositif de sortie (4) ;
- un corps (25) reliant l'entrée (22) à la sortie (20) ;
- des moyens de filtrage (23) du signal délivré par le dispositif d'entrée (2) ;
- une charge adaptée (24) ;
ledit dispositif d'entrée (2) fonctionnant de manière linéaire ou quasi-linéaire sur une bande de fréquence plus importante que le dispositif de sortie (4), lesdits moyens de filtrage (23) assurant la fonction de filtre stop-bande et étant adaptés par ladite charge adaptée (24) au dispositif d'entrée (2) dans toute la bande de fréquence de fonctionnement linéaire ou quasi-linéaire du dispositif d'entrée (2), à l'exception de la bande de fréquence stoppée par lesdits moyens de filtrage (23), la bande de fréquence stoppée correspondant sensiblement à la bande de fréquence (14) dudit signal utile.

2. Dispositif selon la revendication 1 **caractérisé en ce que**, le dispositif de sortie (4) assurant une fonction de filtre passe-haut, les moyens de filtrage (23) assurent la fonction de filtre passe-bas ou passe-bande complémentaire à l'effet de filtrage passe-haut du dispositif de sortie (4), la bande de fréquence stoppée correspondant sensiblement à la bande de fréquence (14) dudit signal utile.

3. Dispositif selon l'une des quelconques revendications précédentes **caractérisé en ce que** le dispositif d'entrée (2) est un amplificateur de puissance et que le dispositif de sortie est un guide d'onde (4).

4. Dispositif selon la revendication 3 **caractérisé en ce qu'**il comporte un élément rayonnant (25) entre un point (A) d'entrée des moyens de filtrage (23) et l'entrée (22), le point A étant maintenu à un potentiel électrique nul ou quasi-nul, des éléments réjecteurs (26) étant intercalés entre le point (A) et la charge adaptée (24).
